(19) Europäisches Patentamt
European Patent Office
Office européen des brevets

(11) **EP 1 671 145 B1**

(12) **FASCICULE DE BREVET EUROPEEN**

(45) Date de publication et mention de la délivrance du brevet:
**22.11.2017 Bulletin 2017/47**

(21) Numéro de dépôt: **04791509.5**

(22) Date de dépôt: **08.10.2004**

(51) Int Cl.:
***G01R 33/02*** *(2006.01)*

(86) Numéro de dépôt international:
**PCT/FR2004/002562**

(87) Numéro de publication internationale:
**WO 2005/036194 (21.04.2005 Gazette 2005/16)**

(54) **DISPOSITIF D'ANALYSE D'UN CIRCUIT ÉLECTRIQUE**

ANALYSEVORRICHTUNG FÜR ELEKTRISCHEN SCHALTUNG

ELECTRIC CIRCUIT ANALYSIS DEVICE

(84) Etats contractants désignés:
**AT BE BG CH CY CZ DE DK EE ES FI FR GB GR HU IE IT LI LU MC NL PL PT RO SE SI SK TR**

(30) Priorité: **08.10.2003 FR 0311772**

(43) Date de publication de la demande:
**21.06.2006 Bulletin 2006/25**

(73) Titulaire: **CENTRE NATIONAL D'ETUDES SPATIALES**
**75001 Paris (FR)**

(72) Inventeurs:
• **DESPLATS, Romain**
  **F-31320 Castanet Tolosan (FR)**
• **CREPEL, Olivier**
  **F-31700 Mondeville (FR)**
• **BEAUDOIN, Félix**
  **CA 94587 Union City (US)**
• **PERDU, Philippe**
  **F-31100 TOULOUSE (FR)**

(74) Mandataire: **Lavoix**
**2, place d'Estienne d'Orves**
**75441 Paris Cedex 09 (FR)**

(56) Documents cités:
**WO-A-98/38792       US-A- 5 132 620**
**US-A- 6 124 712       US-A1- 2002 167 313**
**US-B1- 6 427 314**

**Description**

La présente invention concerne une sonde de mesure d'un champ magnétique comportant au moins un capteur magnéto-résistif ou magnéto-inductif sensible au champ magnétique suivant un axe de mesure privilégié.

Il est envisagé de mesurer le champ magnétique engendré par un circuit électronique en fonctionnement par mise en oeuvre d'un capteur magnéto-résistif et, plus précisément, d'un capteur de type GMR (Giant Magneto Resistor) ou TMR (Tunneling Magnéto Resitance). Ces derniers sont connus comme MTJ (Magnetic Tunnel Junction) et SDT (Spin Dépendent Tunneling).

De tels capteurs magnéto-résistifs sont des éléments électroniques dont la résistance varie en fonction du champ magnétique dans lequel ils sont placés.

Le document US 6 124 712 décrit quelques exemples de capteurs de ce type.

Dans les installations connues actuellement, le capteur magnéto-résistif placé au-dessus du circuit électronique à analyser est relié à une chaîne de traitement.

Ainsi, le capteur magnéto-résistif permet d'obtenir une valeur représentative du champ magnétique engendré en un point par le circuit électronique en fonctionnement. Une telle sonde ne permet pas de caractériser précisément le circuit et ne permet pas notamment de déterminer avec précision la structure du circuit, et notamment la position des pistes qu'il comporte.

L'invention a pour but de proposer une sonde de mesure permettant d'obtenir en plus du champ magnétique engendré par un circuit d'autres informations concernant ce circuit.

A cet effet, l'invention a pour objet un dispositif d'analyse conforme à la revendication 1.

Suivant des modes particuliers de réalisation, le dispositif d'analyse comporte l'une ou plusieurs des caractéristiques des revendications 2 à 10.

L'invention sera mieux comprise à la lecture de la description qui va suivre, donnée uniquement à titre d'exemple et faite en se référant aux dessins, sur lesquels :

- la figure 1 est une vue en perspective d'un dispositif portable d'analyse d'un circuit intégré ;
- la figure 2 est une vue schématique d'un premier mode de réalisation d'un dispositif de mesure d'un champ magnétique selon l'invention ;
- les figures 3 et 4 sont des vues identiques à celle de la figure 2 de variantes de réalisation d'un dispositif de mesure ;
- la figure 5 est une vue schématique en perspective d'une variante de réalisation d'une sonde selon l'invention ;
- la figure 6 est une vue en perspective d'une installation ;
- la figure 7 est une vue en perspective d'une installation d'analyse d'un circuit intégré ;
- la figure 8 est un organigramme explicitant le fonctionnement de l'installation de la figure 7 ;
- la figure 9 est un représentation tridimensionnelle d'une sonde à 9 capteurs adaptées pour mesure les variations de champs dans les trois directions de l'espace ;
- la figure 10 est une installation de test d'un ensemble de circuits intégrés ;
- la figure 11 est une vue schématique d'un premier mode de réalisation d'une sonde de mesure matricielle ; et
- la figure 12 est une vue en élévation schématique d'un second mode de réalisation d'une sonde de mesure matricielle.

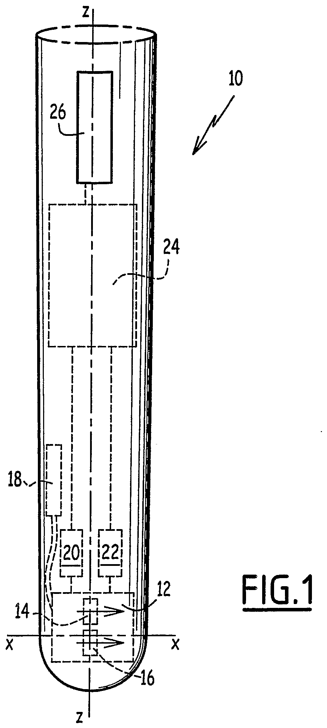

Sur la figure 1 est représenté un dispositif portable de mesure du courant circulant dans un circuit suivant une unique direction.

Le dispositif se présente sous la forme d'un ustensile allongé d'axe Z-Z dont la forme et les dimensions correspondent généralement à celles d'un stylo. Il est donc adapté pour être déplacé manuellement au-dessus d'un circuit avec l'axe Z-Z perpendiculaire au plan du circuit.

Le dispositif comporte à une extrémité une sonde 12 comportant deux capteurs magnéto-résistifs 14, 16 disposés dans deux plans parallèles perpendiculaires à l'axe Z-Z. Sur les dessins, les deux capteurs sont disposés successivement suivant l'axe Z-Z. En pratique, ceux-ci sont avantageusement légèrement décalés transversalement de part et d'autre de l'axe Z-Z pour éviter les problèmes d'écrantage magnétiques potentiels.

La structure de la sonde 12 sera détaillée en regard des figures suivantes.

Chaque capteur magnéto-résistif présente un axe de mesure privilégié indiqué schématiquement par une flèche. La résistance du capteur est influencée essentiellement par la composante du champ magnétique suivant cet axe de mesure privilégié.

Selon l'invention, les axes de mesure privilégiés des deux capteurs 14, 16 sont parallèles l'un à l'autre. Dans l'exemple considéré, ces axes s'étendent parallèlement à l'axe X-X du dispositif, sont perpendiculaires à l'axe longitudinal Z-Z du dispositif.

Le dispositif 10 comporte des moyens 18 d'alimentation des deux capteurs. Ces moyens seront décrits en détails en regard des figures suivantes.

De même, la sonde 12 comporte des bornes de sortie propres à chaque capteur 14, 16 permettant de recueillir un signal représentatif du champ magnétique mesuré par ce capteur.

Chaque capteur 14, 16 est relié à une chaîne de traitement propre 20, 22 permettant le conditionnement du signal issu du capteur. Ces chaînes de traitement sont reliées à une unité de traitement d'informations 24 propre à traiter les signaux représentatifs des composantes du champ magnétique obtenu en sortie des chaînes de traitement 20, 22. Le dispositif comprend en outre un écran d'affichage 26 piloté par l'unité de traitement d'informations 24.

L'écran 26 est propre à afficher la valeur de la dérivée notée $\dfrac{dB_x}{dz}$ de la composante du champ magnétique B suivant l'axe X-X du dispositif par rapport à la direction longitudinale Z-Z passant par les deux capteurs 14, 16.

Le dispositif 10 suivant l'invention fonctionne de la manière suivante. En sortie des chaînes de traitement, deux valeurs de la composante du champ magnétique B suivant la direction X-X notées $B_{x1}$ et $B_{x2}$ sont obtenues. Elles correspondent au champ à l'emplacement des capteurs 14 et 16. A partir de ces deux valeurs de mesure et de la distance connue séparant les capteurs 14 et 16 mesurée suivant l'axe Z-Z, l'unité de traitement d'informations 24 détermine une évaluation de la dérivée $\dfrac{B_x}{dz}$ de la composante du champ magnétique suivant la direction X-X par rapport à la direction Z-Z à partir de la relation $\dfrac{dB_x}{dz} = \dfrac{B_{x2} - B_{x1}}{z_2 - z_1}$ où $z_2$ et $z_1$ sont les positions des capteurs 14 et 12 suivant l'axe Z-Z.

La valeur du courant notée $j_y$ circulant dans le circuit suivant la direction Y-Y perpendiculaire aux deux directions X-X et Z-Z est égale à $\dfrac{dB_x}{dz}$ , de sorte que la valeur calculée par l'unité de traitement d'informations 24 est cette valeur de courant. Cette valeur du courant est affichée sur l'écran 26.

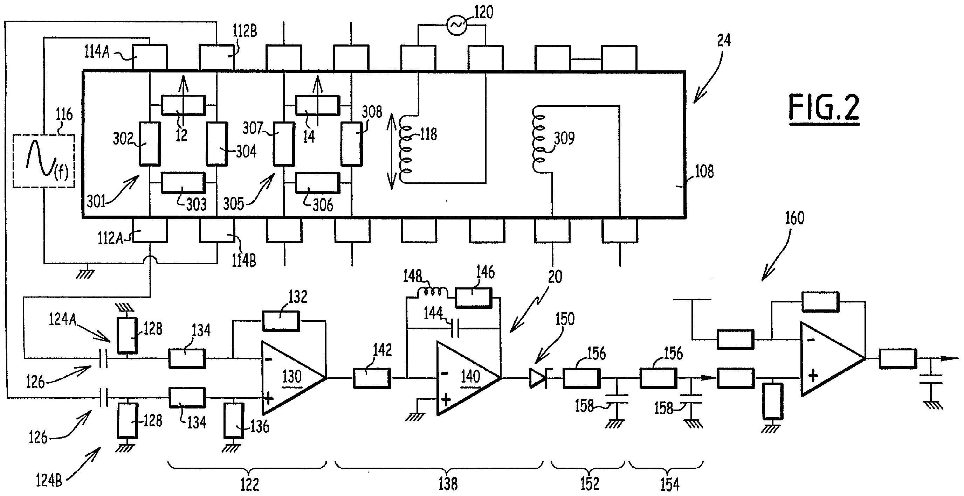

Sur la Figure 2, seul le circuit intégré 108 comportant les capteurs 12 et 14 est représenté. De plus, seul le circuit de traitement 20 associé au capteur 12 est illustré, sachant qu'un circuit de traitement identique est mis en oeuvre pour le capteur 14.

Comme illustré sur la figure 2, le capteur magnéto-résistif 12 est intégré dans un pont de Weston 201 comportant trois autres résistances fixes de valeur prédéterminée 302, 303, 304. Les quatre résistances sont reliées en série pour former une boucle, comme connu en soi dans la structure d'un pont de Weston. Deux des bornes opposées du pont de Weston forment des sorties 112A, 112B de mesure de la sonde 100. Les deux autres bornes du pont de Weston 114A, 114B forment des entrées d'alimentation du pont de Weston. Celles-ci sont reliées aux bornes d'un générateur 116 produisant un signal sinusoïdal de fréquence prédéterminée, cette fréquence étant par exemple égale à 160 KHz.

En outre, et comme connu en soi, la sonde de mesure comporte un bobinage 118 relié à une source extérieure de tension alternative 120. Le bobinage 118 est adapté pour créer un champ de polarisation dans la région du capteur magnéto-résistif afin de réduire l'hystérésis du capteur.

De même, le capteur magnéto-résistif 14 est également intégré dans un pont de Weston 305 comportant trois résistances 306, 307, 308, et un second bobinage 309 est prévu pour créer un champ de polarisation dans la région du capteur magnéto-résistif 14 afin de réduire l'hystérésis. Comme précédemment, le pont de Weston et le bobinage sont reliés à des moyens d'alimentation propres qui ne sont pas représentés pour des raisons de simplification.

Seul le circuit de traitement des signaux issu du capteur magnéto-résistif 12 est décrit dans la suite étant entendu que le circuit relié aux capteurs 14 est identique.

Les sorties 112A, 112B de la sonde de mesure sont reliées à la chaîne de traitement 20.

Celles-ci sont reliées, en entrée, à un étage d'amplification différentielle 122 formant soustracteur par l'intermédiaire de deux filtres passe-haut 124A, 124B aux entrées desquelles sont connectées, respectivement, les bornes de sortie 112A et 112B.

L'étage d'amplification différentielle 122 est dimensionné pour produire un gain, par exemple égal à 100.

Les filtres passe-haut sont des filtres passifs de type RC comportant un condensateur 126 dont une borne est reliée à la masse par une résistance 128.

L'étage d'amplification différentielle est de tout type connu adapté et comporte, par exemple, un amplificateur opérationnel 130 dont la boucle de contre-réaction est équipée d'une résistance 132, les entrées inverseuses et non-inverseuses de l'amplificateur opérationnel étant reliées aux sorties des filtres 124A, 124B par deux résistances d'entrée 134. La borne non-inverseuse de l'amplificateur opérationnel est reliée à la masse par une résistance 136 fixant une tension d'entrée.

La sortie de l'amplificateur différentiel 120 est reliée à l'entrée de moyens 138 d'isolement d'une composante fréquentielle déterminée du signal représentatif du champ magnétique issu de la sonde de mesure. La fréquence de la composante du champ à déterminer est notée FI. Cette fréquence est par exemple égale à 160 kHz.

Dans le mode de réalisation illustré sur la figure 2, ces moyens d'isolement 138 comportent un filtre sélectif actif du type passe-bande centré sur la fréquence FI de la composante fréquentielle à isoler. Cette fréquence est égale à la fréquence F d'excitation du circuit C.

Ce filtre comporte un amplificateur opérationnel 140 dont la borne non-inverseuse est reliée à la masse. La borne inverseuse du filtre est reliée à la sortie de l'étage d'amplification différentielle 122 par une résistance d'entrée 142. La boucle de contre-réaction de l'amplificateur différentiel 140 comprend un condensateur 144 relié en parallèle à une résistance 146, elle-même connectée en série avec une bobine 148.

En sortie, le filtre sélectif 138 présente une diode 150 de type BAT suivie de deux filtres passe-bas passifs 152, 154, chacun formé d'une résistance dont la borne de sortie est reliée à la masse par un condensateur 158.

La chaîne de traitement 20 permet d'obtenir la composante fréquentielle du champ magnétique détecté par le capteur magnéto-résistif à l'aide d'un circuit très simple.

Lors du fonctionnement du dispositif de mesure du champ magnétique, la valeur de la résistance du capteur magnéto-résistif 12 varie en fonction de l'intensité du champ magnétique suivant l'axe de mesure privilégié du capteur. Ainsi, l'amplitude du signal mesuré aux bornes de sortie 112A, 112B varie en fonction du champ magnétique.

Les deux filtres passe-haut 124A, 124B assurent un filtrage des fréquences perturbatrices résultant de l'environnement extérieur.

Le circuit d'amplification différentielle 122 produit en sortie un signal dont l'intensité est proportionnelle à la différence de potentiel entre les deux bornes 122A, 122B. Le filtre sélectif 138 centré sur la fréquence d'excitation du circuit C assure l'isolement de la composante fréquentielle du champ pour cette fréquence.

Les deux filtres passe-bas 152, 154 assurent un nouveau filtrage permettant la suppression des composantes perturbatrices.

Un étage de sortie 160 peut avantageusement être ajouté de manière en enlever la valeur de tension continue mesurée au borne du capteur à vide. Pour cela un amplificateur différentiel est à nouveau utilisé. Le signal de sortie précédent est injecté sur l'entrée inverseuse de l'amplicateur différentielle. Alors que la tension continue de référence est injectée sur l'entrée non inverseuse.

Le réglage de la tension de référence se fait par ajustement de la valeur de la résistance ajustable de manière à mesure une valeur nulle en sortie de ce deuxième amplicateur différentiel. La mesure se fait en polarisant le capteur magnétiquement (pour se décaler dans le cycle d'hystérésis) sans polariser le circuit C.

Le signal issu de la chaîne de traitement est recueilli par l'unité de traitement d'informations.

Ainsi, on comprend que la chaîne de traitement permet l'obtention très rapide d'une valeur de mesure du champ magnétique et plus précisément d'une composante de ce champ magnétique.

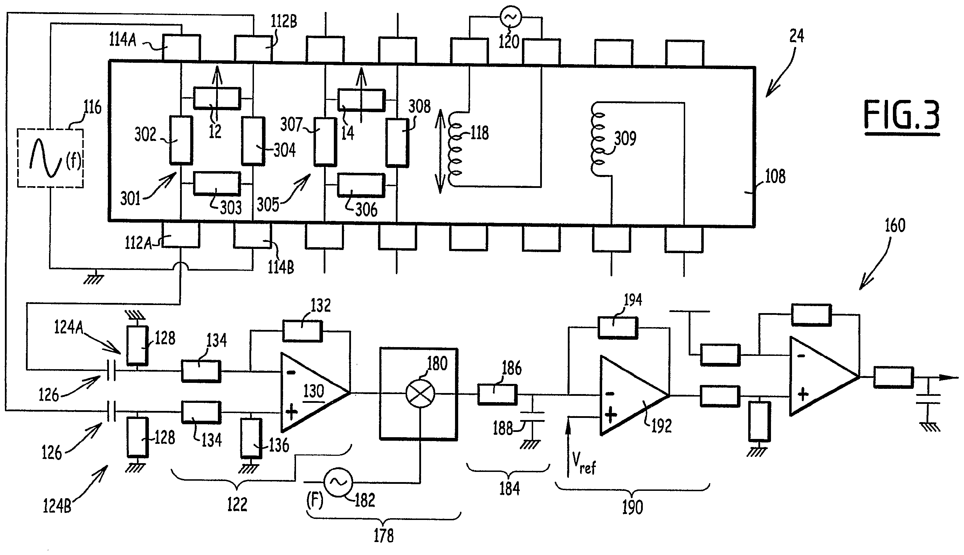

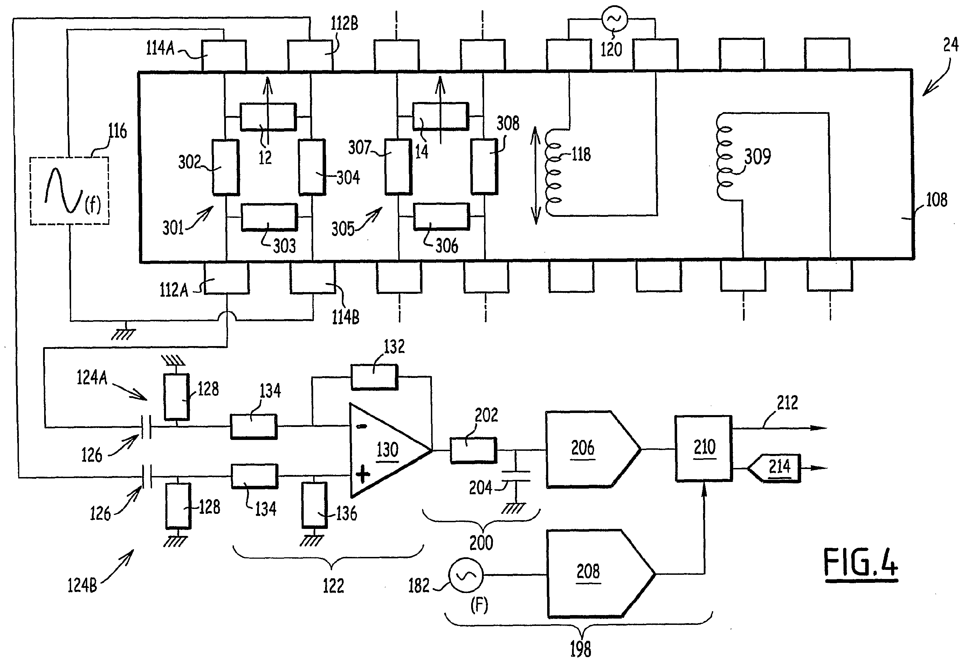

Sur les figures 3 et 4 sont représentées des variantes de réalisation d'un dispositif de mesure selon l'invention. Dans ces modes de réalisation, les éléments identiques ou analogues à ceux de la figure 2 sont désignés par les mêmes numéros de référence.

Dans ces deux variantes de réalisation, seule la chaîne de traitement diffère, par les moyens mis en oeuvre en aval de l'étage d'amplification différentielle 122.

Dans les deux cas, les moyens d'isolement de la composante fréquentielle du champ magnétique pour une fréquence prédéterminée comportent un circuit multiplicateur 180 permettant de combiner le signal issu de l'étage d'amplification différentielle 122 et un signal de référence, dont la fréquence FC est supérieure ou égale à la fréquence f de fonctionnement du circuit imposée par un circuit d'excitation. L'utilisation du multiplicateur donne de la flexibilité quant au choix de la fréquence (160 KHz)

Dans le mode de réalisation de la figure 3, les moyens d'isolement comportent un circuit multiplicateur analogique 180 dont une entrée est connectée en sortie de l'étage d'amplification différentielle 122 et dont l'autre entrée est reliée à un générateur de tension sinusoïdal 182 dont la fréquence de référence F est supérieure à la fréquence prédéterminée FI de la composante fréquentielle à isoler.

Un filtre passe-bas 184 constitué d'une résistance 186 et d'un condensateur 188 est prévu en sortie du circuit multiplicateur. Avantageusement, un circuit soustracteur 190 est prévu en sortie du filtre passe-bas 184 pour assurer la comparaison du signal filtré obtenu en sortie à un signal de référence noté Vref imposé. Le circuit soustracteur comporte un amplificateur opérationnel 192 dont la boucle de contre-réaction présente une résistance 194 adaptée et sur la borne non-inverseuse duquel une tension Vref est appliquée.

Comme dans le mode de réalisation de la figure 2, un étage de sortie 160 est disposé en sortie du circuit soustracteur.

Suivant un mode particulier de réalisation, la source de tension 182 est formée par la source de tension 116 alimentant le pont de Weston 201.

Dans ce mode la fréquence d'alimentation du capteur est identique à la fréquence de la composante fréquentielle recherchée.

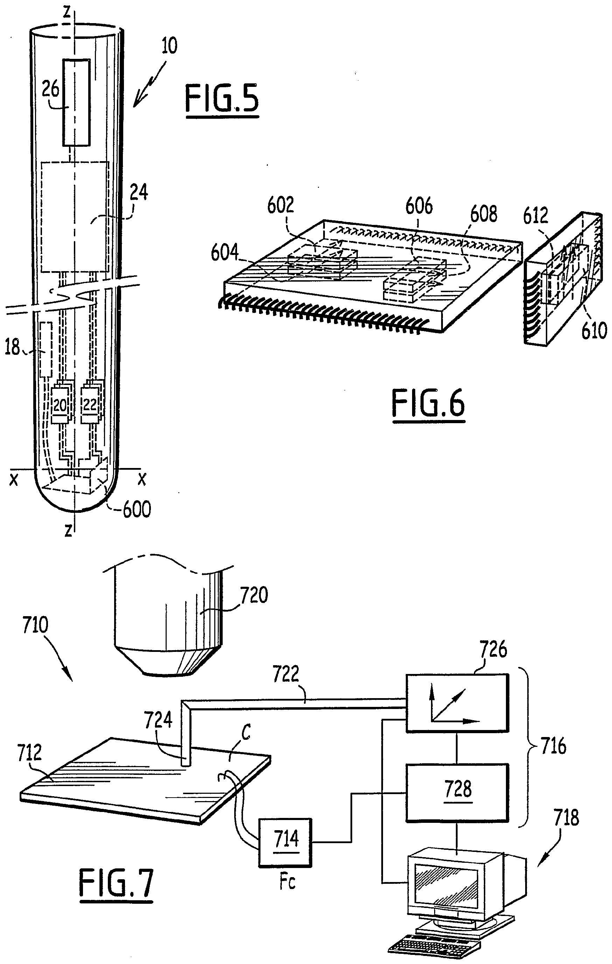

Dans le mode de réalisation de la figure 6, les moyens d'isolement de la composante fréquentielle déterminée sont formés d'un calculateur numérique assurant la multiplication du signal obtenu en sortie de l'étage d'amplification différentielle 122 et d'un signal de référence.

Comme illustré sur la figure 4, un filtre passe-bas 200 constitué d'une résistance 202 et d'un condensateur 204 est prévu en sortie de l'étage d'amplification différentielle. Un convertisseur analogique/numérique 206 est connecté en sortie du filtre 200 afin d'assurer une numérisation du signal.

En outre, la chaîne de traitement intègre, comme précédemment, une source notée également 182, d'une tension sinusoïdale de référence. Un convertisseur analogique/numérique 208 est relié en sortie de cette source 182. Les convertisseurs analogiques/numériques ont une fréquence d'échantillonnage très supérieure à la fréquence des signaux reçus. Celle-ci est par exemple supérieure à 500 kHz.

Un calculateur rapide 210, tel qu'un circuit de type DSP est prévu dans la chaîne de traitement. Il reçoit en entrée les signaux issus des deux convertisseurs analogiques 206 et 208 et est programmé pour assurer une multiplication des deux signaux.

Les signaux multipliés sont ainsi adressés à l'unité de traitement d'informations 24.

Dans ce cas, la multiplication des deux signaux est effectuée par le calculateur 210. L'opération de soustraction effectuée par l'étage de sortie 160 dans les figures 3 et 4 est également assurée par le calculateur 210.

Sur la figure 5 est représentée une variante de réalisation d'un dispositif selon l'invention. Sur cette figure, les éléments identiques ou analogues à ceux de la figure 1 sont désignés par les mêmes numéros de référence.

Dans ce mode de réalisation, la sonde, notée 600 et illustrée à plus grande échelle sur la figure 6 comporte six capteurs magnéto-résistifs répartis en trois paires de capteurs, les capteurs d'une même paire ayant leurs axes de mesure privilégiés parallèles l'un à l'autre. Les axes de mesure privilégiés des trois paires de capteurs sont perpendiculaires les uns aux autres et s'étendent ainsi suivant trois directions principales de l'espace.

Les capteurs d'une même paire sont décalés l'un par rapport à l'autre suivant une direction transversale à leurs axes de mesure privilégiés communs.

Dans ce mode de réalisation, quatre capteurs 602, 604, 606, 608 sont disposés sur un premier circuit intégré, alors que deux autres capteurs 610, 612 sont disposés sur un autre circuit intégré disposé perpendiculairement au premier.

Les capteurs 602, 604, 606, 608 sont répartis suivant deux plans parallèles.

Comme dans le mode de réalisation de la figure 1, les capteurs 602 et 604 sont décalés suivant l'axe Z-Z alors que leurs axes de mesure privilégiés s'étendent suivant l'axe X-X. De même, les capteurs 606, 608 sont décalés suivant l'axe Z-Z mais leurs axes de mesure privilégiés s'étendent suivant l'axe Y-Y perpendiculaire aux axes X-X et Z-Z.

Enfin, les capteurs 610 et 612 sont décalés suivant l'axe X-X, leurs axes de mesure privilégiés étant parallèles à l'axe Z-Z.

Comme illustré schématiquement sur la figure 5, chaque capteur est associé à une chaîne de traitement propre 20, 22 du dispositif de mesure, les sorties des six chaînes de traitement étant reliées à l'unité de traitement d'informations 24 du dispositif.

Dans ce mode de réalisation, l'unité de traitement d'informations 24 est adaptée pour calculer les valeurs de la variation de la composante du champ magnétique selon chacune des directions X-X, Y-Y et Z-Z.

Chaque variation notée respectivement $dB_x$, $dB_y$ et $dB_z$ est déterminée comme la différence des mesures de champ effectuées entre les deux capteurs d'une même paire.

En outre, l'unité de traitement d'informations 24 assure un calcul du module de la variation du champ, ce module étant déterminé par

$$\left|dB\right| = \sqrt{dB_x^2 + dB_y^2 + dB_z^2}.$$

L'utilisation de deux plans de deux capteurs dans les directions X-X et Y-Y permet la recherche de courant dans le plan perpendiculaire à l'axe Z-Z du dispositif. Les mesures différentielles de champs entre les capteurs deux à deux : $dB_x/dz$ et $dB_y/dz$ permettent de remonter à l'expression vectorielle du courant avec les équations de Maxwell : Jx et Jy puisque dBz/dy et dBz/dx sont nuls si le courant ne circule que dans le plan perpendiculaire à l'axe du dispositif.

L'installation 710 illustrée sur la figure 7 est destinée à l'analyse d'un circuit intégré en fonctionnement.

Cette installation comporte essentiellement un plateau 712 de support d'un circuit intégré C, un circuit 714 d'excitation du circuit intégré à une fréquence prédéterminée notée FC, un dispositif 716 d'analyse du champ magnétique engendré par le circuit C en fonctionnement et des moyens 718 d'exploitation des résultats obtenus en sortie du dispositif d'analyse du champ magnétique 716. En outre, l'installation comporte des moyens d'observation 720 du circuit intégré en fonctionnement. Ces moyens sont connus en soi et ne seront pas décrits en détail.

Le support 712 sur lequel est posé le circuit C est formé d'une plaque de mu-métal ou comporte dans sa partie inférieure opposée au circuit une plaque de mu-métal formant une barrière au champ magnétique. Avantageusement, le circuit C est confiné dans une boîte de mu-métal.

Le circuit d'excitation 714 est formé par exemple d'un générateur de fréquence propre à alimenter le circuit à la fréquence prédéterminée FC. Cette fréquence d'excitation FC est par exemple de 160 kHz.

Les moyens d'analyse 716 comportent un bras manipulateur 722 équipé, à son extrémité libre, d'une sonde de mesure 724 propre à déterminer une valeur caractéristique du champ magnétique à l'endroit de la sonde.

Le bras manipulateur 722 est relié à un mécanisme 726 de déplacement de la sonde, permettant, comme connu en soi, de déplacer celle-ci suivant trois directions perpendiculaires les unes aux autres et de connaître avec précision la position de la sonde par rapport au circuit.

En outre, les moyens d'analyse 716 comportent des chaînes de traitement 728 auxquelles est reliée la sonde 724 pour la mise en forme du signal issu de la sonde. Ces chaînes de traitement sont identiques à celles décrites en regard des figures 2, 3 et 4. Elles sont reliées aux moyens d'exploitation 718 pour fournir à ceux-ci une ou plusieurs valeurs traitées du champ magnétique relevé par la sonde 724.

Les moyens d'exploitation 718 sont formés par exemple par un ordinateur de type PC comportant des cartes d'acquisition reliées en sortie des chaînes de traitement 728. Il comporte en outre des cartes de commande permettant le pilotage des moyens d'analyse 716, et plus précisément, des moyens de déplacement 726, de la chaîne de traitement 728 et du circuit d'excitation 714.

Les moyens d'exploitation 718 comportent des modules logiciels permettant le pilotage des moyens d'analyse 716 du champ magnétique, et notamment du circuit d'excitation 714, des moyens de déplacement 726 et des chaînes de traitement 728. Ils comportent en outre des modules logiciels de traitement des signaux issus des moyens d'analyse du champ.

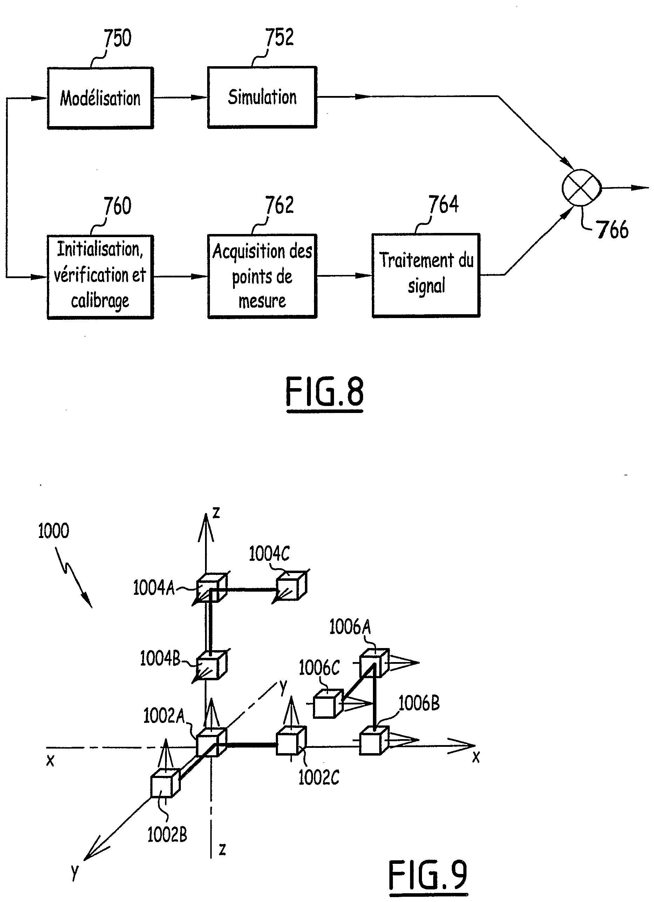

En particulier, les moyens d'exploitation 718 sont propres à mettre en oeuvre l'algorithme illustré sur la figure 8, un module logiciel étant prévu pour chaque étape de l'algorithme.

Pour l'analyse d'un circuit électronique en fonctionnement, une modélisation du circuit peut d'abord être effectuée, à l'étape 750, à partir du tracé du circuit. Cette modélisation, par exemple vectorielle, est conduite à l'aide de tout logiciel adapté. Cette modélisation vise à déterminer la position des différentes pistes et des différents composants électroniques constituant le circuit C.

A l'issue de cette modélisation, une simulation du fonctionnement du circuit est effectuée à l'étape 752. Les caractéristiques du champ magnétique au-dessus du circuit sont déterminées par cette simulation, en chaque point du circuit, notamment par application des équations de Maxwell. Ainsi, il est déterminé, pour chaque élément du circuit, le courant circulant dans celui-ci, ainsi que les trois composantes du champ magnétique notées $B_x$, $B_y$ et $B_z$, en un point de mesure situé immédiatement au-dessus du circuit et pour différentes positions prédéterminées pouvant être occupées par la sonde de mesure 724.

Parallèlement aux étapes de modélisation et de simulation, les moyens d'exploitation 718 commandent une mesure effective du champ magnétique par les moyens d'analyse du champ 716 en chaque point de mesure considéré lors de la simulation.

A l'étape 760, les moyens d'analyse du champ 716 sont d'abord initialisés et calibrés. Leur fonctionnement correct est également vérifié. En outre, des mesures de référence sont effectuées sur un échantillon de calibration connu dont les composantes du champ magnétique qu'il crée sont connues.

Une acquisition des différents points de mesure est ensuite effectuée à l'étape 762. Cette étape consiste à effectuer une mesure d'au moins une composante du champ magnétique en plusieurs points de mesure prédéterminés au-dessus du circuit C en fonctionnement. A cet effet, la sonde est déplacée sous la commande des moyens de déplacement 726 pour balayer la surface du circuit, par exemple en suivant un chemin en boustrophédon. Avant chaque acquisition d'une mesure, la sonde de mesure est arrêtée au point de mesure, afin que le résultat de la mesure ne soit pas affecté par le déplacement de la sonde.

L'acquisition proprement dite de chaque mesure sera décrite dans la suite.

Avantageusement mais non obligatoirement, l'étape 762 prévoit également l'acquisition de points de mesure alors que le circuit C n'est pas en fonctionnement, afin de mesurer en chaque point de mesure la ou les composantes du champ magnétique ambiant.

A l'étape 764, le signal acquis pour chaque point de mesure est traité afin notamment de corriger les erreurs et décalages résultant de la mesure, ces erreurs et décalages étant corrigés par des techniques de comparaison avec la table de données acquises sur un échantillon de référence, lors de l'étape 760.

Lors de l'étape 764, des valeurs issues des mesures du champ suivant une ou plusieurs directions notées $B_x$, $B_y$, $B_z$ sont calculées et notamment les variations spatiales des composantes du champ suivant les trois directions notées $dB_x/dy$, $dB_x/dz$, $dB_y/dz$, $dB_y/dx$, $dB_z/dx$ et $dB_z/dy$.

En outre, les caractéristiques d'intensité et de direction du courant dans le circuit au-dessous du point de mesure sont déterminées par application de la loi de Maxwell J = Rot B où J est le vecteur courant et B le vecteur champ magnétique.

A l'étape 766, les valeurs issues de l'étape du traitement de signal 764 et les valeurs obtenues suite à la simulation effectuée à l'étape 752 sont comparées afin de déduire si le fonctionnement réel du circuit est correct ou non, et déterminer les zones de discordance entre le circuit théorique et le circuit réel en fonctionnement.

La tête de mesure 724 est constituée par exemple d'une sonde 1000 tel qu'illustrée sur la figure 9. Cette sonde est adaptée pour effectuer une mesure différentielle du champ suivant trois directions perpendiculaires deux à deux.

Une telle sonde comporte neuf capteurs. Ces neuf capteurs sont répartis sous forme de trois triplets de capteurs, les capteurs d'un même triplet ayant leurs axes de mesure privilégiés disposés parallèlement l'un à l'autre. Ces capteurs sont en outre décalés les uns des autres suivant deux directions perpendiculaires à l'axe de mesure privilégié caractérisant le triplet.

Plus précisément, dans l'exemple illustré sur la figure 9, trois capteurs 1002A, 1002B, 1002C ont leurs axes de mesure privilégiés disposés parallélement à l'axe X-X. Ces capteurs 1002A et 1002B sont décalés l'un de l'autre suivant l'axe X-X alors que les capteurs 1002A et 1002B sont décalés suivant l'axe X-X. De même, les capteurs 1004A, 1004B, 1004C ont leur axe de mesure privilégié parallèle à l'axe Y-Y, le capteur 1004C étant décalé du capteur 1004A suivant l'axe X-X alors que le capteur 1004B est décalé du capteur 1004A suivant l'axe Z-Z. Enfin, les trois capteurs 1006A, 1006B, 1006C ont leur axe de mesure s'étendant parallèlement à l'axe X-X, les capteurs 1006A et 1006B étant décalés par rapport au capteur 1006A respectivement suivant l'axe Z-Z et suivant l'axe Y-Y.

Dans l'installation décrite en regard des figures 7 et 8, chaque capteur est relié à une chaîne de traitement propre et les neuf valeurs de champ sont fournies au moyen d'exploitation 718. En outre, les moyens d'exploitation 718 connaissent la distance séparant les différents capteurs d'un même triplet suivant les directions perpendiculaires aux axes de mesure privilégiés des capteurs de ce triplet. Ainsi, pour chaque point de mesure, les moyens d'exploitation déterminent à partir des composantes mesurées par les capteurs la variation de chaque composante du champ magnétique suivant chacune des directions. A partir de ces différentes variations, les différentes composantes notées $j_x$, $j_y$ et $j_z$ suivant les trois directions perpendiculaires X-X, Y-Y et Z-Z du courant circulant dans le circuit en test C sont calculées grâce au relation suivante :

$$J_x = \frac{dB_z}{dy} - \frac{dB_y}{dz}$$

$$J_y = \frac{dB_x}{dz} - \frac{dB_z}{dx}$$

$$J_z = \frac{dB_y}{dx} - \frac{dB_x}{dy}$$

On conçoit qu'avec un tel dispositif, le courant circulant dans le circuit peut être déterminé avec précision pour chaque point de mesure. En multipliant les points de mesure, la structure du circuit en test peut être reconstituée et son fonctionnement dynamique peut être analysée avec précision.

Sur la figue 10 est représentée une variante de la figure 7. Dans ce mode de réalisation, la tête de mesure 724 est remplacée par une matrice 1100 comportant un ensemble de capteurs disposés régulièrement en ligne et en colonne. Cette matrice de capteurs permet le test d'un ensemble de circuits intégrés portés par une galette de silicium 1102, les circuits étant disposés côte à côte. La matrice de capteurs comporte des groupes de capteurs répartis en lignes et en colonnes et correspondant chacun à un circuit à tester de la galette 1102.

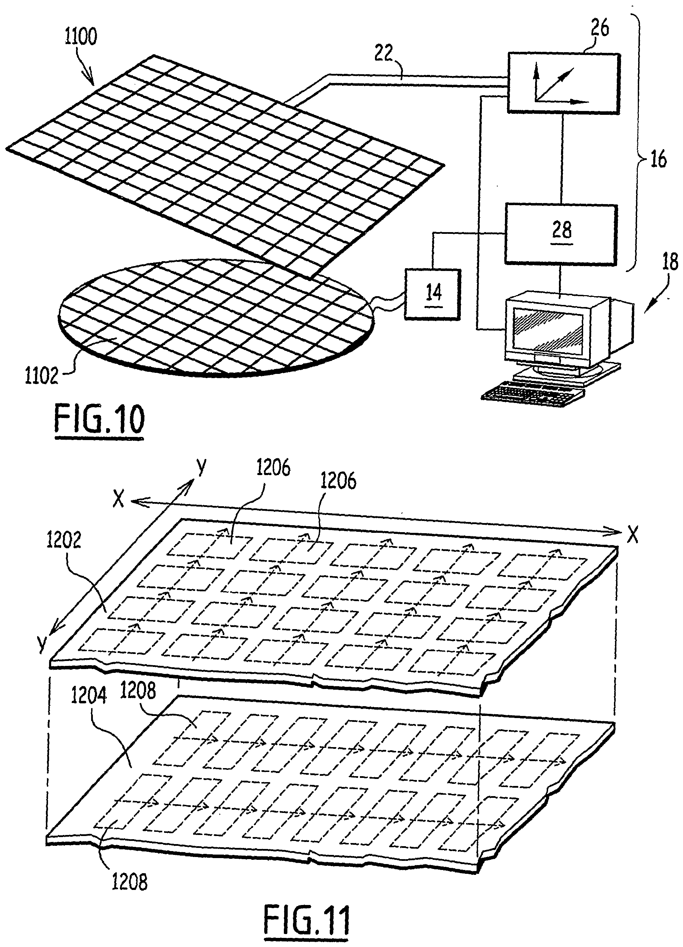

Un groupe de capteurs est partiellement représenté sur la figure 11. Un tel groupe de capteurs comporte par exemple 5000 capteurs magnéto-résistifs disposés eux-mêmes en lignes et en colonnes. Chacun de ces capteurs est relié au dispositif d'analyse par l'intermédiaire d'un circuit de traitement propre. Les groupes de capteurs comportent des capteurs dont les axes de mesure privilégiés sont disposés parallèlement les uns aux autres suivant deux directions perpendiculaires l'une à l'autre. Ces directions perpendiculaires s'étendent dans un plan parallèle au plan général des circuits à tester. En effet, la composante du courant perpendiculairement au plan principal du circuit est généralement de peu d'intérêt.

Cette matrice est utilisée pour acquérir rapidement une image du champ magnétique d'une galette de circuits intégrés. Pour une matrice de taille donnée, les capteurs seront répartis sur deux plans. Un plan suivant la direction X et l'autre plan suivant la direction Y.

Avantageusement, une seconde matrice, identique à la précédente est utilisée, tournée de 90 degrés. Ainsi, le plan de dessous, précédemment X devient le plan Y et le plan de dessus devient le plan X. En utilisant ces deux matrices on aura un ensemble de mesure de champ X et champ Y à deux altitudes Z données. En combinant ces mesures de manière différentielle entre les deux altitudes, l'expression du courant suivant les équations de maxwell sont alors obtenues.

Dans le mode de réalisation, de la figure 11, la matrice de capteur comporte deux couches superposées 1202, 1204. Chaque couche comporte un réseau régulier de capteurs magnéto-résistifs. Les capteurs 1206 de la première couche sont disposés avec leurs axes de mesure privilégiés parallèles, les capteurs étant répartis en lignes et en colonnes perpendiculaires les unes aux autres. De même, la seconde couche comporte des capteurs 1208 dont les axes de mesure privilégiés sont parallèles les uns aux autres et perpendiculaires aux axes de mesure des capteurs de la première couche.

Sur les deux couches, les capteurs sont espacés les uns des autres suivant une direction perpendiculaire à leur axe de mesure privilégié et s'étendant dans le plan de la couche portant les capteurs d'un pas prédéterminé connu. Ainsi, dans l'exemple considéré, au droit de chaque capteur, les moyens d'exploitation déterminent les composantes $j_x$ et $j_y$ du courant circulant dans le plan principal du circuit à partir des relations suivantes :

$$J_x = -\frac{dBy}{dz}$$

$$J_y = \frac{dBx}{dz}$$

Pour obtenir ces valeurs, la matrice est amenée successivement dans deux positions d'écartement distinct suivant la direction Z-Z par rapport au circuit à tester. Des mesures sont faites dans ces deux positions séparées d'un intervalle $d_z$ et les quantités $dB_y$ et $dB_x$ sont calculées par soustraction des valeurs relevées.

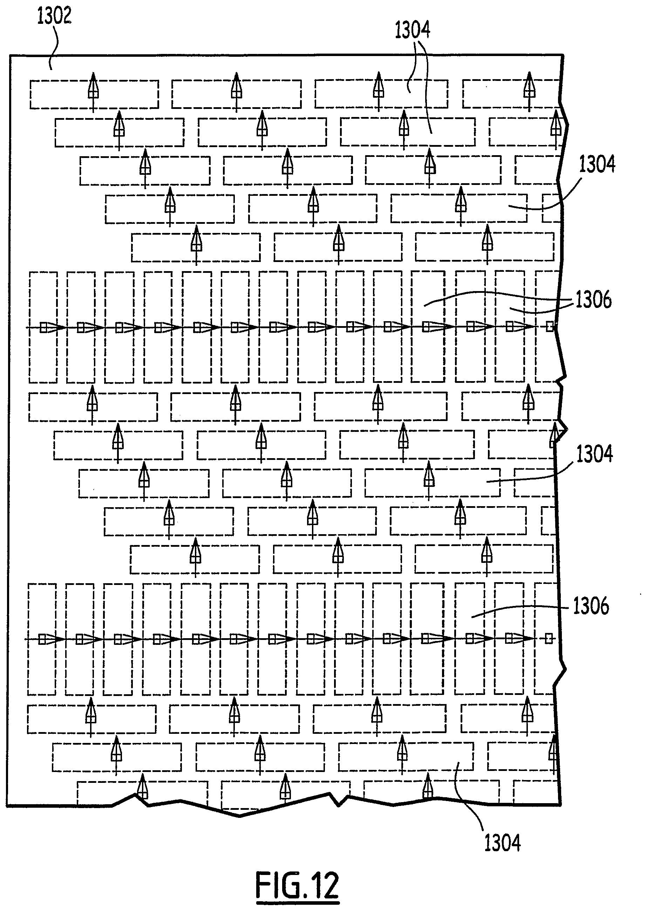

Sur la figure 12 est représenté un autre mode de réalisation d'une sonde selon l'invention, cette sonde constituant un groupe de capteurs de la matrice de capteurs 1100 de la figure 10.

Dans ce mode de réalisation, les différents capteurs magnéto-résistifs sont définis sur une même couche 1302 d'un matériau supra-conducteur. Chaque capteur présente une forme rectangulaire, l'élément magnéto-résistif n'étant formé que par la partie centrale du capteur schématisé par un carré sur la figure.

Cette sonde est constituée d'une alternance de plusieurs lignes de capteurs ayant un axe de mesure privilégié disposé suivant une première direction X-X et de ligne de capteurs dont l'axe de mesure privilégié s'étend suivant un axe Y-Y. Plus précisément, cinq lignes de capteurs magnéto-résistifs 1304 ayant leurs axes de mesure privilégiés parallèles à l'axe X-X se succèdent suivant l'axe X-X. Les capteurs sont décalés d'une ligne à l'autre d'une distance égale à 1/5$^{ème}$ de la longueur d'un capteur magnéto-résistif, la longueur étant prise perpendiculairement à l'axe de mesure privilégié. La ligne de capteurs notés 1306 dont l'axe de mesure privilégié est orienté suivant l'autre direction de mesure est constituée d'un alignement de capteurs magnéto-résistifs alignés rigoureusement suivant le même axe.

Cette configuration prend en compte la nature rectangulaire des capteurs magnéto-résistifs. Suivant la taille du rectangle par rapport à l'élément active de mesure de champ située au centre du rectangle le rapport 1/5 est modifié.

Avantageusement, une deuxième matrice est disposée parallèlement, dans un plan au dessus de la première. Cette deuxième matrice est organisée d'une manière comparable mais, alternativement, l'ensemble des capteurs suivant l'axe Y-Y est positionné au dessus de l'ensemble des capteurs suivant l'axe X-X et les capteurs suivant l'axe X-X au dessus des capteurs suivant l'axe Y-Y. Ainsi, une mesure différentielle entre des capteurs suivant l'axe X-X entre les deux plans est obtenue après balayage. La mesure différentielle est faite deux à deux entre deux mesures d'un capteur suivant l'axe X-X d'un plan inférieur à un endroit donné et d'un capteur suivant l'axe X-X du plan supérieur au même endroit. Après balayage l'ensemble de la surface est couverte par une mesure des champs $B_X$ et $B_Y$ sur deux plans (deux altitudes z) en tout point.

En variante, les capteurs magnéto-résistifs sont remplacés par des capteurs magnéto-inductifs.

## Revendications

1. Dispositif d'analyse d'un circuit électrique en fonctionnement, comportant :

   - au moins une sonde de mesure d'un champ magnétique comportant au moins deux capteurs magnéto-résistifs ou magnéto-inductifs (14, 16), chaque capteur magnéto-résistif ou magnéto-inductif étant sensible au champ magnétique suivant un axe de mesure privilégié, les capteurs magnéto-résistifs ou magnéto-inductifs étant rigidement liés l'un à l'autre dans une position telle que leurs axes de mesure privilégiés sont parallèles et décalés l'un de l'autre suivant une direction transversale à leurs axes de mesure privilégiés, la sonde comportant des bornes de sortie propres à chaque capteur magnéto-résistif ou magnéto-inductif pour fournir un signal représentatif du champ magnétique mesuré par chaque capteur suivant son axe de mesure privilégié ;

   le dispositif étant **caractérisé en ce qu'**il comprend en outre :

   - une chaîne de traitement (20, 22) propre à chaque capteur magnéto-résistifs ou magnéto-inductif (14, 16) ; et
   - des moyens (24, 26) d'exploitation des signaux issus des différentes chaînes de traitement, lesquels moyens d'exploitation sont adaptés pour évaluer le rapport de la différence des valeurs de champ relevés par deux capteurs magnéto-résistifs ou magnéto-inductifs d'axes de mesure privilégiés parallèles et décalés transversalement à la distance séparant les deux capteurs magnéto-résistifs ou magnéto-inductifs.

2. Dispositif selon la revendication 1, **caractérisé en ce que** la sonde comporte au moins deux paires de capteurs magnéto-résistifs ou magnéto-inductifs (602, 604, 606, 608, 610, 612), les capteurs de chaque même paire ayant leurs axes de mesure privilégiés parallèles et décalés l'un de l'autre suivant une direction transversale à leurs axes de mesure privilégiés et les axes de mesure privilégiés des capteurs de deux paires distinctes sont décalés angulairement.

3. Dispositif selon la revendication 2, **caractérisé en ce que** la sonde comporte au moins neuf capteurs magnéto-résistifs ou magnéto-inductifs (1002A, 1002B, 1002C, 1004A, 1004B, 1004C, 1006A, 1006B, 1006C) répartis en trois triplets de trois capteurs, les trois capteurs d'un même triplet ayant leurs axes de mesure privilégiés parallèles et décalés les uns des autres suivant des directions transversales à leurs axes de mesure privilégiés et les axes de mesure privilégiés des capteurs de triplets distincts sont décalés angulairement.

4. Dispositif selon la revendication 1, **caractérisé en ce que** tous les capteurs magnéto-résistifs ou magnéto-inductifs (602, 604, 606, 608 ; 1206, 1208) de la sonde sont répartis suivant deux couches (1202, 1204).

5. Dispositif selon la revendication 4, **caractérisé en ce que** les axes de mesure privilégiés des capteurs de couches différentes sont décalés angulairement.

6. Dispositif selon la revendication 5, **caractérisé en ce que** les capteurs (1206, 1208) d'une même couche ont leurs axes de mesure privilégiés parallèles.

7. Dispositif selon l'une quelconque des revendications 1 à 6, **caractérisé en ce que** tous les capteurs magnéto-résistifs ou magnéto-inductifs (1304, 1306) de la sonde sont répartis sur une même couche.

**8.** Dispositif selon l'une quelconque des revendications précédentes, **caractérisé en ce qu'**il comporte des moyens (26) d'affichage du rapport de la différence des valeurs de champ relevés par deux capteurs magnéto-résistifs ou magnéto-inductifs (14, 16) d'axes de mesure privilégiés parallèles et décalés transversalement à la distance séparant les deux capteurs magnéto-résistifs ou magnéto-inductifs et **en ce que** ledit dispositif est adapté pour être tenu à la main et déplacé manuellement.

**9.** Dispositif selon la revendication 2, dans lequel les moyens d'exploitation sont propres à évaluer, pour chaque paire de capteurs (602, 604, 606, 608) le rapport de la différence des valeurs de champ relevés par deux capteurs magnéto-résistifs ou magnéto-inductifs d'axes de mesure privilégiés parallèles et décalés transversalement à la distance séparant les deux capteurs magnéto-résistifs ou magnéto-inductifs et les moyens d'exploitation sont propres à calculer au moins une composante du courant par différence entre lesdits rapports évalués.

**10.** Dispositif selon la revendication 9, **caractérisé en ce qu'**il comporte des moyens (26) d'affichage d'au moins une composante du courant calculée et **en ce que** ledit dispositif est adapté pour être tenu à la main et déplacé manuellement.

**Patentansprüche**

**1.** Vorrichtung zum Analysieren einer elektrischen Schaltung während des Betriebs, die Folgendes umfasst:

    - wenigstens eine Sonde zum Messen eines Magnetfeldes, die wenigstens zwei magnetoresistive oder magnetoinduktive Sensoren (14, 16) enthält, wobei jeder magnetoresistive oder magnetoinduktive Sensor für das Magnetfeld längs einer bevorzugten Messachse empfindlich ist, wobei die magnetoresistiven oder magnetoinduktiven Sensoren an einer Position starr miteinander verbunden sind, derart, dass ihre bevorzugten Messachsen zueinander parallel und längs einer Richtung, die zu ihren bevorzugten Messachsen transversal ist, voneinander versetzt sind, wobei die Sonde Ausgangsanschlüsse, die zu jedem magnetoresistiven oder magnetoinduktiven Sensor gehören, aufweist, um ein Signal zu liefern, das das gemessene Magnetfeld für jeden Sensor längs seiner bevorzugten Messachse darstellt;

wobei die Vorrichtung **dadurch gekennzeichnet ist, dass** sie ferner umfasst:

    - eine Verarbeitungskette (20, 22) für jeden magnetoresistiven oder magnetoinduktiven Sensor (14, 16); und
    - Mittel (24, 26) zum Auswerten der Signale, die von den verschiedenen Verarbeitungsketten stammen, wobei die Auswertungsmittel dafür ausgelegt sind, das Verhältnis der Differenz der Feldwerte auszuwerten, die von zwei magnetoresistiven oder magnetoinduktiven Sensoren, deren bevorzugte Messachsen zueinander parallel und zu dem Abstand, der die beiden magnetoresistiven oder magnetoinduktiven Sensoren voneinander trennt, transversal sind, erfasst werden.

**2.** Vorrichtung nach Anspruch 1, **dadurch gekennzeichnet, dass** die Sonde wenigstens zwei Paare von magnetoresistiven oder magnetoinduktiven Sensoren (602, 604, 606, 608, 610, 612) umfasst, wobei die Sensoren derselben Paare bevorzugte Messachsen haben, die zueinander parallel und voneinander längs einer Richtung, die zu ihren bevorzugten Messachsen transversal ist, versetzt sind, während die bevorzugten Messachsen von Sensoren zweier verschiedener Paare in Winkelrichtung versetzt sind.

**3.** Vorrichtung nach Anspruch 2, **dadurch gekennzeichnet, dass** die Sonde wenigstens neun magnetoresistive oder magnetoinduktive Sensoren (1002A, 1002B, 1002C, 1004A, 1004B, 1004C, 1006A, 1006B, 1006C) umfasst, die auf drei Tripletts aus je drei Sensoren verteilt sind, wobei die drei Sensoren desselben Tripletts bevorzugte Messachsen besitzen, die zueinander parallel und in Richtungen, die zu ihren bevorzugten Messachsen transversal sind, voneinander versetzt sind, während die bevorzugten Messachsen von Sensoren verschiedener Tripletts in Winkelrichtung versetzt sind.

**4.** Vorrichtung nach Anspruch 1, **dadurch gekennzeichnet, dass** die magnetoresistiven oder magnetoinduktiven Sensoren (602, 604, 606, 608; 1206, 1208) der Sonde längs zweier Schichten (1202, 1204) verteilt sind.

**5.** Vorrichtung nach Anspruch 4, **dadurch gekennzeichnet, dass** die bevorzugten Messachsen von Sensoren verschiedener Schichten in Winkelrichtung zueinander versetzt sind.

**6.** Vorrichtung nach Anspruch 5, **dadurch gekennzeichnet, dass** die Sensoren (1206, 1208) derselben Schicht zueinander parallele bevorzugte Messachsen haben.

**7.** Vorrichtung nach einem der Ansprüche 1 bis 6, **dadurch gekennzeichnet, dass** die magnetoresistiven oder magnetoinduktiven Sensoren (1304, 1306) der Sonde in derselben Schicht verteilt sind.

8. Vorrichtung nach einem der vorhergehenden Ansprüche, **dadurch gekennzeichnet, dass** sie Mittel (26) zum Anzeigen des Verhältnisses der Differenz der Feldwerte, die von zwei magnetoresistiven oder magnetoinduktiven Sensoren (14, 16) erfasst werden, deren bevorzugte Messachsen zueinander parallel und zu dem Abstand, der die beiden magnetoresistiven oder magnetoinduktiven Sensoren voneinander trennt, transversal versetzt sind, umfasst und dass die Vorrichtung dafür ausgelegt ist, mit der Hand gehalten und manuell verlagert zu werden.

9. Vorrichtung nach Anspruch 2, wobei die Auswertungsmittel in der Lage sind, für jedes Paar von Sensoren (602, 604, 606, 608) das Verhältnis der Differenz der Feldwerte, die von zwei magnetoresistiven oder magnetoinduktiven Sensoren erfasst werden, deren bevorzugte Messachsen zueinander parallel und zu dem Abstand, der die beiden magnetoresistiven oder magnetoinduktiven Sensoren voneinander trennt, transversal versetzt sind, auszuwerten, und die Auswertungsmittel dafür ausgelegt sind, wenigstens eine Stromkomponente anhand der Differenz zwischen ihren ausgewerteten Verhältnissen zu berechnen.

10. Vorrichtung nach Anspruch 9, **dadurch gekennzeichnet, dass** sie Mittel (26) zum Anzeigen wenigstens einer berechneten Stromkomponente umfasst und dass die Vorrichtung dafür ausgelegt ist, mit der Hand gehalten und manuell verlagert zu werden.

**Claims**

1. Device for analysing an electrical circuit during operation, comprising:

   - at least one probe for measuring a magnetic field comprising at least two magnetoresistive or magnetoinductive sensors (14, 16), each magnetoresistive or magnetoinductive sensor being sensitive to the magnetic field along a selected measurement axis, the magnetoresistive or magnetoinductive sensors being rigidly connected to each other in a position such that their selected measurement axes are parallel and offset relative to each other in a transverse direction relative to their selected measurement axes, the probe comprising output terminals which are specific to each magnetoresistive or magnetoinductive sensor in order to provide a signal which is representative of the magnetic field measured by each sensor along the selected measurement axis thereof;

**characterised in that** it further comprises:

   - a processing chain (20, 22) which is specific to each magnetoresistive or magnetoinductive sensor (14, 16);
   - means (24, 26) for processing the signals from the various processing chains, which processing means are suitable for evaluating the relationship of the difference between the field values measured by two magnetoresistive or magnetoinductive sensors having selected measurement axes which are parallel and which are offset transversely relative to each other at the distance separating the two magnetoresistive or magnetoinductive sensors.

2. Device according to claim 1, **characterised in that** the probe comprises at least two pairs of magnetoresistive or magnetoinductive sensors (602, 604, 606, 608, 610, 612), the sensors of each same pair having their selected measurement axes parallel and offset relative to each other in a transverse direction relative to their selected measurement axes and the selected measurement axes of the sensors of two separate pairs are angularly offset.

3. Device according to claim 2, **characterised in that** the probe comprises at least nine magnetoresistive or magnetoinductive sensors (1002A, 1002B, 1002C, 1004A, 1004B, 1004C, 1006A, 1006B, 1006C) which are distributed in three triplets of three sensors, the three sensors of the same triplet having their selected measurement axes parallel and offset relative to each other in transverse directions relative to their selected measurement axes and the selected measurement axes of the sensors of separate triplets are angularly offset.

4. Device according to claim 1, **characterised in that** all the magnetoresistive or magnetoinductive sensors (602, 604, 606, 608; 1206, 1208) of the probe are distributed in accordance with two layers (1202, 1204).

5. Device according to claim 4, **characterised in that** the selected measurement axes of the sensors of different layers are angularly offset.

6. Device according to claim 5, **characterised in that** the sensors (1206, 1208) of the same layer have their selected measurement axes parallel.

7. Device according to any one of claims 1 to 6, **characterised in that** all the magnetoresistive or magnetoinductive sensors (1304, 1306) of the probe are distributed on the same layer.

8. Device according to any one of the preceding claims, **characterised in that** it comprises means (26) for displaying the relationship of the difference between the field values measured by two magnetoresistive or magnetoinductive sensors (14, 16) having selected measurement axes which are parallel and which are offset transversely at the distance separating the two magnetoresistive or magnetoinductive sensors, and **in that** the device is suitable for being held by hand and manually displaced.

9. Device according to claim 2, wherein the processing means are capable of evaluating, for each pair of sensors (602, 604, 606, 608), the relationship of the difference between the field values measured by two magnetoresistive or magnetoinductive sensors having selected measurement axes which are parallel and which are offset transversely at the distance separating the two magnetoresistive or magnetoinductive sensors and the processing means are capable of calculating at least one component of the current from the difference between the evaluated relationships.

10. Device according to claim 9, **characterised in that** it comprises means (26) for displaying at least one calculated component of the current, and **in that** the device is suitable for being held by hand and manually displaced.

**FIG.1**

FIG.2

FIG.3

FIG.4

EP 1 671 145 B1

FIG.5

FIG.6

FIG.7

750 Modélisation
752 Simulation

760 Initialisation, vérification et calibrage
762 Acquisition des points de mesure
764 Traitement du signal

766

FIG.8

1000

1004C
1004A
1004B

1006A
1006C
1006B

1002A
1002C
1002B

FIG.9

FIG.10

FIG.11

**FIG.12**

**EP 1 671 145 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6124712 A